# EUROPÄISCHE PATENTANMELDUNG

(11) **EP 0 952 238 A1**
(43) Veröffentlichungstag der Anmeldung: **27.10.1999**
(21) Anmeldenummer: 99102681.6
(22) Anmeldetag: 12.02.1999
(51) Int. Cl.: C23C 14/06, C23C 14/02, C23C 28/00

(54) **Mehrlagen-Hartstoffschicht**

(30) Priorität: 14.04.1998 DE 19816491
(71) Anmelder: Hauzer Industries B.V., 5900 AE Venlo (NL)
(72) Erfinder: Fleischer, Werner, Dr., 5988 KG Helden (NL); Trinh, Thong, 6291 BP Vaals (NL)
(74) Vertreter: Manitz, Finsterwald & Partner

(57) **Zusammenfassung**

Es wird eine Mehrlagen-Hartstoffschicht beschrieben, wobei eine Topschicht der Kategorie Me-C:H Verwendung findet.

## Beschreibung

Die Erfindung betrifft eine Mehrlagen-Hartstoffschicht aus Nitriden, Carbiden oder Carbonitriden mit den Metallkomponenten Ti, Zr, Nb, Cr, TiAl und/oder TiNb.

Aufgabe der Erfindung ist es, eine Mehrlagen-Hartstoffschicht zu schaffen, die sich vor allem für Trockenbearbeitungsvorgänge aber auch beispielsweise für Formen als Antihaftschicht für entsprechende Anwendungsfälle eignet.

Eine Mehrlagen-Hartstoffschicht nach der Erfindung, welche diese Forderungen erfüllt, umfaßt eine Ein- oder Mehrlagenschicht aus Nitriden, Carbiden oder Carbonitriden mit den Metallkomponenten Ti, Zr, Nb, Cr, TiAl und/oder TiNb, wobei wesentlich ist, daß auf diese Ein- oder Mehrlagenschicht eine Ein- oder Mehrlagentopschicht der Kategorie Me-C:H abgeschieden ist.

Die Metallkomponente besteht dabei vorzugsweise aus W, Ti, Nb, Zr oder Cr.

Die Ein- oder Mehrlagentopschicht ist bevorzugt als Gradientenschicht ausgebildet, derart, daß der Anteil C, H mit dem Schichtwachstum zunimmt. Die Schichtdicken der aufgebrachten Schichten sind vorzugsweise von der Substratoberfläche bis zur Schichtoberfläche ungleich, und die Einzelschichten können unterschiedliche Komponenten in den Nitriden, Carbonitriden oder Carbiden enthalten.

Bevorzugt werden diese Hartstoffschichten durch die PVD-Methode entweder in einem durchgehenden Prozeß oder in zwei Stufen aufgebracht, wobei als PVD-Methode die Arc- oder Sputtertechnik eingesetzt wird.

Weitere besonders vorteilhafte Ausführungsformen der Erfindung sind in den Unteransprüchen angegeben.

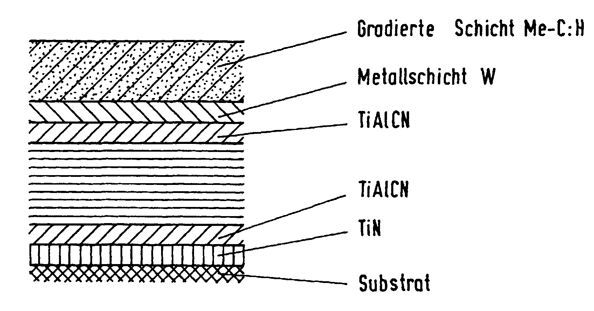

Ein Ausführungsbeispiel der Erfindung ist in der Zeichnung dargestellt, deren einzige Figur ein Beispiel für einen typischen Schichtaufbau nach der Erfindung zeigt.

Mehrlagen-Hartstoffschichten nach der Erfindung sind vor allem für Werkzeuge bestimmt und eignen sich insbesondere zur Trockenbearbeitung, wobei neben der Härte der Schicht vor allem die geringe Reibung und die Antiklebeeigenschaften, die erzielt werden, von Bedeutung sind.

Die erfindungsgemäßen Mehrlagen-Hartstoffschichten können auch in vielen anderen Anwendungsfällen eingesetzt werden, z.B. bei Formen als Antihaftschicht mit Verschleißschutz. Die erfindungsgemäß vorgesehene Topschicht ist bevorzugt eine Gradientenschicht, die sich wiederum bevorzugt von den darunterliegenden Lagen in der Metallkomponente unterscheidet.

Ein typisches Beispiel für einen erfindungsgemäßen Schichtaufbau ist in der Zeichnung zu sehen, wobei auf ein Substrat eine Mehrlagenschicht aus den angegebenen Komponenten aufgebracht und als Topschicht eine gradierte Schicht Me-C:H aufgebracht ist. Ein Schichtaufbau dieser Art zeichnet sich durch sehr geringe Reibung, besonders als gute Antihafteigenschaften sowie dadurch aus, daß der Schichtaufbau zu einer sehr harten und damit auch für die Trockenbearbeitung besonders geeigneten Schicht führt.

Das Aufbringen sämtlicher Schichten erfolgt in einem durchgehenden Prozeß, aber es kann auch in einem zweistufigen Verfahren erfolgen. Das Aufbringen der Schichten geschieht nach der bekannten Physical Vapor Deposition-Methode, wobei die Arc- oder Sputtertechnik für alle Schichten eingesetzt werden kann. Die Topschicht der Kategorie Me-C:WH wird bevorzugt durch Sputtern in einer zweiten Verfahrensstufe aufgebracht.

## Patentansprüche

1. Mehrlagen-Hartstoffschicht, umfassend eine Ein- oder Mehrlagenschicht aus Nitriden, Carbiden oder Carbonitriden mit den Metallkomponenten Ti, Zr, Nb, Cr, TiAl und/oder TiNb, wobei auf diese Ein- oder Mehrlagenschicht eine Ein- oder Mehrlagentopschicht der Kategorie Me-C:H abgeschieden ist.

2. Mehrlagenschicht nach Anspruch 1, dadurch gekennzeichnet, daß die Metallkomponente (Me) aus W, Ti, Nb, Zr oder Cr besteht.

3. Mehrlagenschicht nach Anspruch 1 oder 2, dadurch gekennzeichnet, daß zwischen der Ein- oder Mehrlagentopschicht der Kategorie Me-C:H und der darunter liegenden Hartstoffschicht eine Interfaceschicht in Form einer Metallschicht, vorzugsweise aus W, Ti, Nb, Zr oder Cr aufgebracht ist.

4. Mehrlagenschicht nach einem der Ansprüche 1 bis 3, dadurch gekennzeichnet, daß die Me-C, H-Schicht eine Gradientenschicht derart darstellt, daß der Anteil C, H mit dem Schichtwachstum zunimmt.

5. Mehrlagenschicht nach einem der Ansprüche 1 bis 4, dadurch gekennzeichnet, daß die Schichtdicke der Ein- oder Mehrlagentopschicht der Kategorie M-C:H im Bereich von 0,5 bis 4 µm gelegen ist.

6. Mehrlagenschicht nach einem der Ansprüche 1 bis 5, dadurch gekennzeichnet, daß die Schichtdicken der aufeinanderfolgenden Schichten von der Substratoberfläche bis zur Topschichtoberfläche zumindest teilweise ungleich sind.

7. Mehrlagenschicht nach einem der Ansprüche 1 bis 6, dadurch gekennzeichnet, daß in der chemischen Zusammensetzung der Einzelschichten unterschiedliche Komponenten hinsichtlich der Nitride, Carbonitride oder Carbide enthalten sind.

8. Verfahren zur Herstellung einer Mehrlagenschicht nach einem oder mehreren der vorhergehenden Ansprüche, dadurch gekennzeichnet, daß die einzelnen Schichten durch die PVD-Methode (Physical Vapor Deposition) in einem Prozeß oder in zwei Stufen aufgebracht werden.

9. Verfahren nach Anspruch 8, dadurch gekennzeichnet, daß für beide Schichten, nämlich die Ein- oder Mehrlagen-Hartstoffschicht und die Ein- oder Mehrlagentopschicht als PVD-Methode die Arc- oder Sputtertechnik zum Aufbringen der Schichten verwendet wird.

10. Verfahren nach Anspruch 9, dadurch gekennzeichnet, daß bei einer zweistufigen Schichtaufbringung die Hartstoffschicht, z.B. eine TiAlN-Schicht nach der Arc-Technik in der ersten Schicht und die Topschicht in Form einer W-C:H-Schicht mit der Sputtertechnik aufgebracht wird.
